# EUROPÄISCHE PATENTSCHRIFT

(11) **EP 0 459 987 B1**
(45) Veröffentlichungstag und Bekanntmachung des Hinweises auf die Patenterteilung: **06.10.1993**
(21) Anmeldenummer: 90901546.3
(22) Anmeldetag: 16.01.1990
(51) Int. Cl.: H05K 5/00

(54) **GERÄTEGEHÄUSE MIT ZWEI GEHÄUSESCHALEN**
TWIN-SHELL HOUSING FOR APPLIANCES
BOITIER BICOQUE POUR APPAREILS

(30) Priorität: 19.01.1989 DE 3901515
(43) Veröffentlichungstag der Anmeldung: 11.12.1991
(73) Patentinhaber: PHYWE-SYSTEME GMBH, 37079 Göttingen (DE)
(72) Erfinder: THIELE, Rolf, D-3400 Göttingen (DE); KRÜLL, Frans, D-3400 Göttingen (DE); OBERDORFER, Dietmar, D-3400 Göttingen (DE); LUCAS-NÜLLE, Rolf, D-5014 Kerpen (DE)
(74) Vertreter: Bauer, Wulf, Dr.
(86) Internationale Anmeldenummer: DE9000018
(87) Internationale Veröffentlichungsnummer: WO9008452

(56) Entgegenhaltungen:
- EP-A- 0 127 164
- FR-A- 1 408 204
- FR-A- 2 491 284
- FR-A- 2 550 907

## Beschreibung

Die Erfindung bezieht sich auf ein Gerätegehäuse mit zwei Gehäuseschalen, von denen die eine die Oberwand und jeweils ein oberes Seitenwandteil der beiden Seitenwände und die andere die Unterwand und jeweils ein unteres Seitenwandteil der beiden Seitenwände ausbildet, wobei die beiden Gehäuseschalen über an den Seitenwandteilen angeordnete Befestigungsmittel, die eine die Seitenwandteile jeder Seitenwand zusammenziehende Spannkraft ausüben, lösbar miteinander verbindbar sind und im zusammengesetzten Zustand vorn eine rechteckförmige Öffnung für die formschlüssige Aufnahme einer Frontplatte aufweisen. Ein derartiges Gerätegehäuse ist aus der FR-A-1 408 204 vorbekannt.

Ausgehend von dem Gerätegehäuse der eingangs genannten Art hat sich die Erfindung die Aufgabe gestellt, dieses vorzugsweise aus Kunststoff herzustellende Gerätegehäuse so weiterzubilden, daß die Verbindung der beiden Gehäuseschalen keinen merklichen Platz im Innenraum und außerhalb des Gerätegehäuses beansprucht, rasch zu lösen und wiederherzustellen ist und auch bei Fehlbedienung praktisch nicht zerstört werden kann.

Ausgehend von dem Gerätegehäuse der eingangs genannten Art wird diese Aufgabe gelöst durch die Merkmale des Patentanspruchs 1.

Die Haken und/oder die Nasen können als einzelne Elemente nebeneinander oder als durchgehendes Profil ausgeführt sein. Der Riegel kann entweder unter Ausnutzung der Elastizität seines Materials quer zur Seitenwand über die Haken gedrückt werden, bis seine Nasen über die Haken schnappen und der gewünschte Formschluß erreicht ist, oder er wird in Längsrichtung der Haken bzw. Nasen aufgeschoben, diese Ausführung wird bevorzugt. Dabei können die Haken bzw. Nasen in Abständen unter Freilassung von Unterbrechungsbereichen angeordnet sein, so daß der Riegel nicht über die gesamte Tiefe der Seitenwand geschoben werden muß, sondern nur ein Teilstück dieser Tiefe bewegt werden muß, daß der Länge der Profilteilstücke entspricht.

Die erfindungsgemäße Ausbildung der Verbindung der Gehäuseschalen eines Gerätegehäuses ermöglicht eine sehr rasche Montage und Demontage, die weitgehend ohne Hilfsmittel erfolgen kann und bei der keine Gefahr einer Verletzung oder Beschädigung einzelner Verbindungselemente besteht. Ein besonderer Vorteil ist auch darin zu sehen, daß die Verbindung der beiden Seitenwandteile jeder Seitenwand so gestaltet werden kann, daß ein Anpressen weitgehend über die gesamte Länge der freien Kante der Seitenwandteile erfolgt. Im Gegensatz hierzu wirkt eine Schraubenverbindung, wie bei vorbekannten Stand der Technik, lediglich punktuell und müssen Maßnahmen vorgesehen sein, daß die Schraubenverbindung sich auch auf die Randbereiche auswirkt. Bei der erfindungsgemäßen Schieberbefestigung sind derartige Maßnahmen, die zumeist zu einem erhöhten Einsatz von Material führen, nicht notwendig, weil der Anpreßdruck zwischen den beiden Seitenwandteilen über die gesamte Länge der freien Kante verteilt werden kann.

Der vorgeschlagene Riegel kann als besonderes gestalterisches Element des Gerätegehäuses eingesetzt werden. Hierzu kann seine Außenfläche beliebig gestaltet und in Abstimmung mit den Flächen der Gehäuseschalen ausgeführt werden. So kann der Riegel beispielsweise eine andere Farbe als die üblicherweise gleichfarbigen Seitenwandteile haben.

Schließlich läßt sich die erfindungsgemäße Verbindung der Gehäuseschalen eines Gerätegehäuses durch elastische Mittel unterstützen und verbessern, diese wiederum sorgen für einen Ausgleich, wenn eine Abnutzung oder ein Fließen des Materials stattgefunden hat und vergleichmäßigen die Kraft, die die beiden Gehäuseschalen gegeneinander zieht, wobei insbesondere örtliche Kraftspitzen vermieden werden.

Weiterhin liegt ein Vorteil der erfindungsgemäßen Anordnung darin, daß Winkel und Gehäuseschalen aus vergleichbaren Materialien, insbesondere Kunststoff, hergestellt werden können. Die häufig problematische Kombination von Kunststoff mit einem harten Metall, wie es bei den Schraubverbindungen, die überlicherweise durch Metallschrauben erfolgen, der Fall ist, wird somit umgangen. Dies ist ein Beitrag zur bereits beschriebenen größeren Lebensdauer der Schieberverbindung im Vergleich zu Schraubenverbindungen für Gehäuseschalen aus Kunststoff.

Grundsätzlich ist die Erfindung jedoch nicht auf Gehäuseschalen aus Kunststoff eingegrenzt, vielmehr können die Gehäuseschalen aus anderem Material, beispielsweise einem Metall, insbesondere Leichtmetall, hergestellt sein. Ein besonderer Vorteil der Erfindung liegt darin, daß beide Gehäuseschalen identisch (baugleich) ausgebildet werden können. Dies vereinfacht die Herstellung, es wird nur eine Form pro Gehäuseschale benötigt.

In einer bevorzugten Weiterbildung der Erfindung sind an mindestens einem Seitenwandteil jeder Gehäuseschale und an den Riegeln Arretierungsmittel für eine lösbare Fixierung der Riegel vorgesehen. Diese können beispielsweise in Form einer federnden Arretierungszunge ausgeführt sein, die am Riegel vorspringt und in eine Ausnehmung eines Seitenwandteils eingreift. Diese Arretierungszunge ist durch ein Loch zugänglich, durch das eine Schraubendreherklinge gesteckt werden kann, um die Arretierungszunge zu lösen. Andere Formen der Arretierung sind möglich. Hierzu gehört beispielsweise eine Arretierung im Bereich der Haken bzw. Nasen, hierzu wird der Riegel unter Ausnutzung seiner Elastizität über einen Vorsprung geschoben und hakt anschließend so ein, daß er erst nach erneuter elastischer Verformung wieder entfernt werden kann.

Um die Verbindung der beiden Gehäuseschalen mittels des Riegels dauerhaft auszubilden, wird vorgeschlagen, zwischen den Riegeln und den Haken oder zwischen den freien Kanten der Gehäuseschalen elastische Mittel, beispielsweise eine gegebenenfalls gewellte Blattfeder, einen elastischen Gummistrang, elastische Noppen oder dergleich anzuordnen, die die Seitenwandteile einer Seitenwand voneinanderweg vorbelasten. Dies führt dazu, daß Toleranzen bei der Herstellung ausgeglichen werden können, Abnutzungen entgegengewirkt wird und auch bei einer Materialermüdung die Verbindung der beiden Seitenwandteile kein Spiel bekommt.

In einer bevorzugten Weiterbildung sind die Haken und/oder die Nasen geringfügig gegenüber dem Verlauf der freien Kante des Seitenwandteils geneigt angeordnet. Dies kann durch eine Schrägstellung des Verlaufs der Haken oder Nasen oder durch Vorsprünge, beispielsweise Noppen, auf den Haken oder Nasen erreicht werden, wobei die Vorsprünge eine abnehmende bzw. zunehmende Höhe haben. Insgesamt wird hierdurch erreicht, daß beim Einschieben des Riegels die Anpreßkraft der beiden Seitenwandteile aufeinanderzu ständig ansteigt und die gewünschte Anpreßkraft erreicht ist, wenn der Riegel vollständig eingeschoben ist.

Um einer Ermüdung des Riegels entgegenzuwirken, wird vorgeschlagen, den Riegel im Bereich gegenüberliegender Nasen zu verstärken, beispielsweise durch Glasfaser- oder Metalleinlagen, oder die Nasen durch ein hartes Material, insbesondere ein Metall, zu überziehen. Als sehr vorteilhaft hat es sich auch herausgestellt, an den Nasen Vorsprünge vorzusehen, die ein Übermaß haben und abgefeilt werden können, so daß jeweils eine paßgenaue Verbindung zweier Gehäuseschalen durch einen Riegel ermöglicht wird.

Schließlich hat es sich als sehr vorteilhaft erwiesen, daß jede Gehäuseschale im Bereich ihrer Oberseite bzw. Unterseite eine Mulde aufweist, in die alternativ entweder ein Tragegriff (für den Fall der Oberwand) oder Stützfüße (für den Fall der Unterwand) eingeklippst werden können. In einer vorteilhaften Weiterbildung wird der Traggriff als Stützfuß benutzt, separate Stützfüße sind in diesem Fall nicht notwendig. Insgesamt wird somit nur eine Muldenform benutzt, es sind keine unterschiedlichen Mulden für den Traggriff bzw. die Stützfüße - wie dies nach dem Stand der Technik der Fall ist - notwendig. Dadurch wird das Ziel, baugleiche Gehäuseschalen für Ober- und Unterseite verwenden zu können, erreicht.

Durch Kombination von Gehäuseschalen, die sich lediglich in der Länge ihrer Seitenwandteile unterscheiden, können unterschiedliche Gehäuse hergestellt werden. Allein bei zwei Typen von Gehäuseschalen mit unterschiedlicher Länge der Seitenwandteile können drei verschieden große Gehäuse erstellt werden, nämlich einmal durch Kombination von zwei Gehäuseschalen mit den jeweils kurzen Seitenwandteilen, einmal durch Kombination einer Gehäuseschale mit kurzen und einer Gehäuseschale mit langen Seitenwandteilen und einmal durch Kombination zweier Gehäuseschalen mit langen Seitenwandteilen. Die zu erreichende Vielfalt läßt sich vergrößern, wenn drei oder mehr unterschiedliche Gehäuseschalen, die sich lediglich in der Länge ihrer Seitenwandteile unterscheiden, vorliegen.

Weitere Merkmale und Vorteile der Erfindung ergeben sich aus den übrigen Ansprüchen sowie der nun folgenden Beschreibung von nicht einschränkend zu verstehenden Ausführungsbeispielen, die unter Bezugnahme auf die Zeichnung näher erläutert werden. In dieser zeigen:
- Fig. 1: eine Draufsicht auf eine Gehäuseschale,
- Fig. 2: eine Rückansicht entsprechend der Pfeile II - II in Fig. 1, teilweise in geschnittener Darstellung,
- Fig. 3: eine Seitenansicht entsprechend der Pfeile III - III in Fig. 1,
- Fig. 4: einen Schnitt entlang der Schnittlinie IV - IV in Fig. 1,
- Fig. 5: einen Schnitt entlang der Schnittlinie V - V in Fig. 1,
- Fig. 6: eine Draufsicht auf die Innenfläche eines Riegels,
- Fig. 7: einen Schnitt entlang der Schnittlinie VII - VII in Fig. 6,
- Fig. 8: eine Ansicht entsprechend der Pfeile VIII - VIII in Fig. 6,
- Fig. 9: einen Schnitt entlang der Schnittlinie IX - IX in Fig. 6 und
- Fig. 10: eine Frontansicht in schematischer Darstellung auf einen aus zwei Gehäuseschalen unterschiedlicher Seitenwandteilhöhen zusammengesetztes Gehäuse.

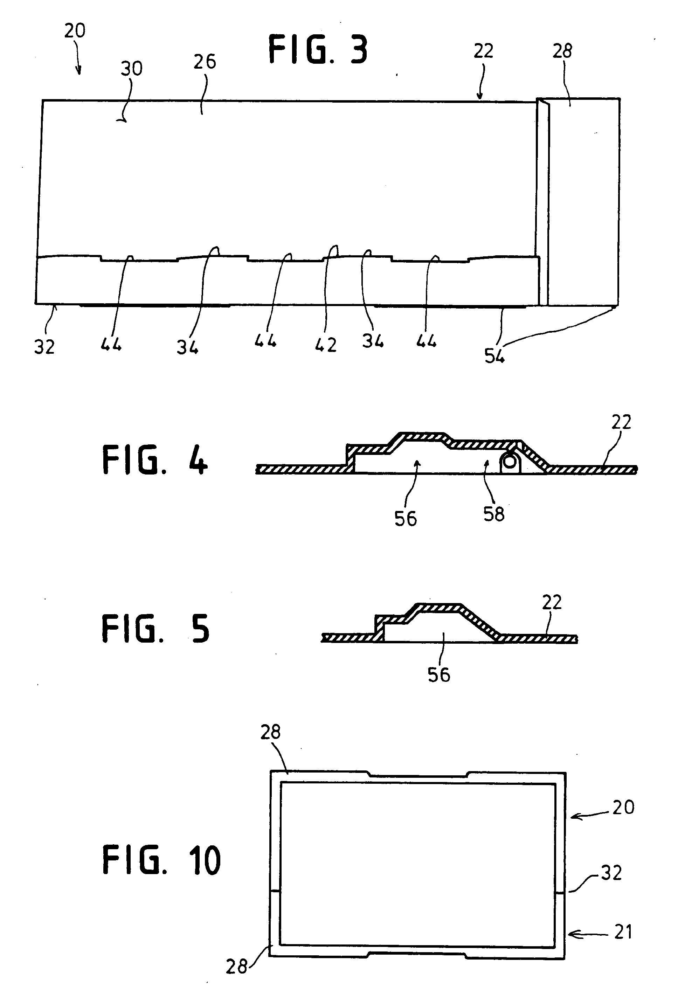

Im gezeigten Ausführungsbeispiel ist jeweils nur eine Gehäuseschale und nur ein Riegel 40 dargestellt, für ein komplettes Gerätegehäuse benötigt man zwei Gehäuseschalen und zwei Riegel 40, sowie eine Frontplatte und gegebenenfalls eine rückwärtige Platte. Die Gehäuseschale 20 bildet eine vollständige Oberwand 22 bzw. Unterwand des Gerätegehäuses sowie jeweils ein Seitenwandteil 24, 26 der beiden Seitenwände des Gerätegehäuses. Im gezeigten Ausführungsbeispiel wird die obere Gehäuseschale beschrieben. Die beiden Gehäuseschalen eines Gerätegehäuses sind bis auf gegebenenfalls eine unterschiedliche Höhe ihrer Seitenwandteile 24, 26, was im folgenden noch anhand von Fig. 10 erläutert wird, baugleich ausgeführt. Wenn im folgenden speziell eine obere Gehäuseschale 20 beschrieben wird, gilt dies nur zur besseren Erläuterung, die Ausführungen treffen ebenso auf eine untere Gehäuseschale zu.

Die Oberwand 22 der Gehäuseschale 20 ist im wesentlichen rechteckförmig. Im vorderen Bereich weicht die Form der Oberwand 22 jedoch von der Rechteckform ab, hier ist ein wenige Zentimeter breiter Wulst 28 vorgesehen, in dem die Seitenwandteile 24, 26 wenige Millimeter nach außen parallel versetzt verlaufen. Der Versatz beträgt etwa 3 bis 4 mm. In der Ebene der Oberwand 22 macht sich der rahmenartig ausgebildete Wulst 28 geringer bemerkbar, er springt etwa 1 bis 2 mm gegenüber der restlichen Fläche der Oberwand 22 vor. Innerhalb des Wulstes befindet sich eine (hier nicht dargestellte) Frontplatte des Gerätegehäuses, der Wulst 28 hat in ansich bekannter Weise an seiner Innenfläche mehrere formschlüssige Aufnahmen, insbesondere Rillen, für den Einsatz und das Festklemmen (beim Zusammenbau der Gehäuseschalen) einer im wesentlichen rechteckförmigen Frontplatte.

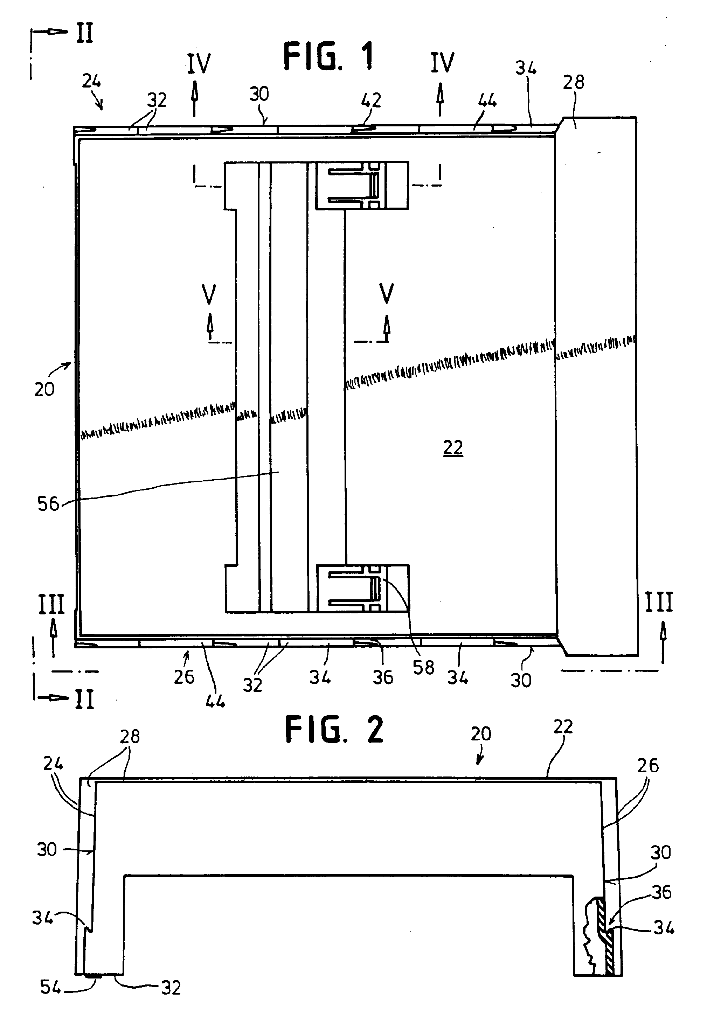

Hinter dem Wulst 28 (von vorn gesehen) befinden sich an den Seitenwandteilen 24, 26 Befestigungsmittel, auf die im folgenden eingegangen wird: An jedem Seitenwandteil 24, 26 springen an der jeweiligen Außenfläche 30 und im wesentlichen parallel zu einer freien Kante 32 der Seitenwandteile 24, 26 Haken 34 vor, deren Hakenspitze nach oben in die Ebene der Oberwand 22 weist. Im gezeigten Ausführungsbeispiel sind insgesamt vier längliche Hakenprofile gezeigt, deren Hakenform sich aus der Darstellung in Fig. 2 ersehen läßt. Zwischen der Hakenspitze und der benachbarten Fläche des zugehörigen Seitenwandteils wird eine Rille 36 ausgebildet, die einige Millimeter hoch, beispielsweise 2 mm hoch ist und etwa eine entsprechende Breitenabmessung hat. Im gezeigten Ausführungsbeispiel ist sie V-förmig, eine beliebige andere Ausführung ist jedoch möglich. Entscheidend bei der Ausbildung der Haken 34 ist lediglich, daß ein Widerlager an der Außenfläche 30 der Seitenwandteile 24, 26 ausgebildet wird, an dem mittels eines noch später zu beschreibenden Riegels 40 eine Kraft auf das Seitenwandteil 24 bzw. 26 einwirken kann, die einerseits dieses Seitenwandteil in Richtung auf die andere Gehäuseschale zu spannt und andererseits verhindert, daß der diese Spannkraft aufbringende Riegel 40 in Querrichtung zum Seitenwandteil 24 bzw. 26 abgezogen werden kann. Entscheidend ist damit die Ausbildung der Rille 36, die einen Hinterschnitt und damit ein Einhaken von Spannmitteln, die sich im Riegel 40 befinden, ermöglicht.

Im konkreten Ausführungsbeispiel nach den Figuren befindet sich im Bereich des Hakens 34 ein Parallelversatz der Wand des Seitenwandteils 24, 26, hierdurch ergibt sich eine besonders einfache Konstruktion, andere Ausführungen sind jedoch hierdurch nicht ausgeschlossen. So können in einer anderen Ausführung in der Wand der Seitenwandteile 24 und 26 Langlöcher vorgesehen sein, die im wesentlichen parallel zur freien Kante 32 verlaufen und mit ihrem unteren, der freien Kante 32 zugewandten Lochrand Haken 34 bilden. Die Rillen 36 befinden sich dann auf der Innenseite des Seitenwandteils 24, 26.

Im gezeigten Ausführungsbeispiel befinden sich die Haken 34 in einem Abstand von einigen Zentimetern, beispielsweise 2 cm, von der freien Kante 32. Dieser Abstand ist grundsätzlich frei wählbar, er kann größer oder kleiner ausgeführt sein. Durch ihn wird jedoch die Breite des Riegels 40 bestimmt.

Im gezeigten Ausführungsbeispiel sind die profilförmig ausgeführten Haken 34 etwa 28 mm lang, sie setzen sich zusammen aus einer Anlaufschräge 42 von etwa 10 mm Länge und einem exakt parallel zur freien Kante 32 verlaufenden, eigentlichen Hakenbereich. Die Anlaufschräge erleichtert die Montage, innerhalb der 10 mm Länge der Anlaufschräge steigt diese um etwa 1 mm an. Zwischen diesen Hakenbereichen 34 befinden sich Unterbrechungsbereiche 44, die länger sind als die Hakenbereiche. In ihnen sind keine Haken vorgesehen.

Anstelle profilförmig ausgeführter Haken 34 können auch vereinzelte, individuelle Haken vorgesehen sein. Grundsätzlich kommt es bei der Ausbildung der Haken nur darauf an, daß eine Hakennase, die in die Ebene der Oberwand 22 weist, gebildet wird, die hintergriffen werden kann, so daß Spannmittel angesetzt werden können.

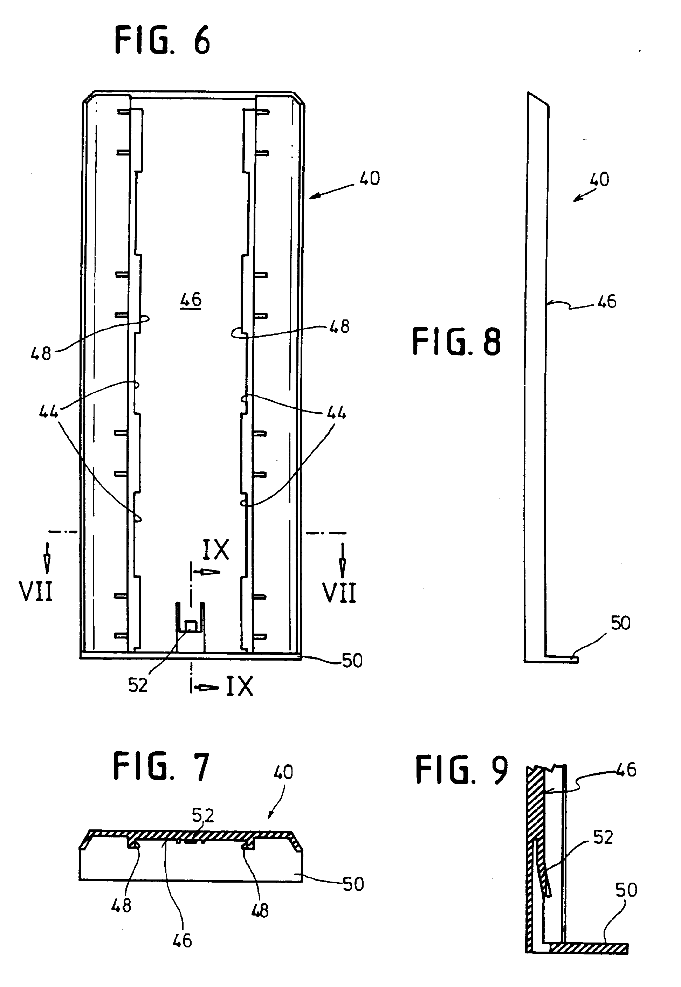

Der Riegel 40 ist ein im wesentlichen rechteckförmiger, flacher Streifen, wie insbesondere die Figuren 6 und 7 zeigen. Er hat an seiner Innenwand 46 den Haken 34 entsprechend ausgebildete Nasen, die aufeinanderzu weisen und wiederum zusammen mit der Innenwand 46 eine Rille begrenzen, die V-förmig ist und die bereits erwähnten Abmessungen hat. Insgesamt wird durch die Haken 34 zweier Gehäuseschalen und die Nasen 48 eines Riegels eine sogenannte Schwalbenschwanzführung ausgebildet. Die Nasen 48 unterscheiden sich nur dadurch von den Haken 34, daß keine Anlaufschräge 42 vorgesehen ist. Letztere könnte alternativ auch an den Riegeln vorgesehen sein. In den Unterbrechungsbereichen 44 zwischen den Haken 34 bzw. zwischen den Nasen 48 sind die eigentlichen Vorsprünge, die im wesentlichen eine V-Profilform haben, nicht ausgebildet, für die Seitenwandteile 24 bzw. 26 verbleibt damit eine durch rechtwinkligen Versatz ausgebildete Schulter, für den Riegel 40 verbleibt eine im wesentlichen rechtwinklig zur Innenwand 46 vorspringende Leiste.

Beim Aufsetzen des Riegels auf zwei zusammengefüge Seitenwandteile 24 zweier Gehäuseschalen 20 wird der Riegel zunächst in seiner Längsrichtung verschoben aufgesetzt in einer Position, in der seine Hakenbereiche 34 in Unterbrechungsbereiche 44 des Riegels 40 eingreifen. Diese Position findet der Benutzer beim praktischen Einsatz durch leichtes Verschieben des Riegels 40 in dessen Längsrichtung, sie äußert sich dadurch, daß der Riegel 40, der leicht zum Seitenwandteil 24 bzw. 26 gedrückt wird, in die Unterbrechungsbereiche 44 hineinfällt. Im weiteren Verlauf der Verbindung zweier Seitenwandteile 24 zweier Gehäuseschalen 20 wird dann der Riegel in seiner Längsrichtung verschoben, der Verschiebeweg entspricht im wesentlichen der Länge der Haken 34 bzw. der im wesentlichen gleichlangen Nasen 48. Durch die beschriebene Ausbildung der Leisten bzw. des Versatzes im Bereich der Seitenwandteile 24 bzw. 26 wird die Montage deutlich vereinfacht, weil bereits eine Führung erzielt wird, bevor die Nasen 48 hinter die Haken 34 und umgekehrt greifen.

Im konket gezeigten Ausführungsbeispiel muß der Riegel stets nach hinten versetzt angebracht werden und auf den Wulst 28 zu geschoben werden, wäre kein Wulst vorgesehen, könnte auch die andere Bewegungsrichtung ausgebildet sein.

Der Riegel hat eine Gesamtbreite, die dem Maß des Versatzes des Wulstes 28 in der Ebene der Seitenwände entspricht. Dadurch schließt der eingerastete Riegel 40 mit seiner Außenfläche bündig an den Wulst 28 an. Im gezeigten Ausführungsbeispiel befindet sich im Versatz des Wulstes ein Winkel von 120°, der Riegel 40 ist entsprechend (siehe Fig. 8) angeschrägt, so daß auch hier eine flächige Anlage erzielt wird.

Der Riegel 40 hat nicht nur Verbindungsfunktion, er wird auch als Gestaltungselement des Gehäuses eingesetzt. Er bewirkt eine Streckung der Seitenwände und kann durch farblich unterschiedliche Ausbildung betont werden. In einer bevorzugten Ausführung bilden die Gehäuseschalen 20 im Bereich der Rückwand eine Aussparung, die ebenso breit ist wie die beiden Riegel des Gehäuses und mit dem Riegel fluchtet. Dadurch ergibt sich ein optisch geschlossen wirkendes Band, das beginnend vom Wulstrand entlang der Seitenflächen und der Rückwand geschlossen U-förmig umläuft.

Im gezeigten Ausführungsbeispiel hat der Riegel 40 noch einen im wesentlichen rechtwinklig wegstehenden, kurzen Anschlag 50, der bei montiertem Riegel 40 mit seiner Innenfläche an die Rückwand anschlägt. Er erleichtert das Betätigen des Riegels und kann als Handhabe für diesen benutzt werden.

Der Riegel ist im Profil (siehe Fig. 7) im wesentlichen U-förmig. Hierdurch wird Material gespart und Freiraum für die Nasen 48 geschaffen. Die Außenfläche des Riegels 40 ist dekorativ gestaltet, beispielsweise mit mehreren Längsnuten versehen, die noch den Längeneindruck des Riegels 40 verstärken.

Fig. 9 zeigt ein elastisches Arretierungsmittel in Form einer einstückig mit dem Riegel 40 ausgebildeten Federzunge 52. Sie ist über eine im Anschlag 50 vorgesehene Öffnung durch die Klinge eines Schraubendrehers oder dergleichen lösbar. Sie steht gegenüber der Innenfläche 46 des Riegels vor und schnappt aufgrund ihres Schrägverlaufs in ansich bekannter Weise selbsttätig in eine entsprechende Öffnung des Seitenwandteils 24 bzw. 26 ein, wenn der Riegel 40 in die Spannposition geschoben wird.

Gehäuseschale 20 und Riegel 40 sind aus einem ausreichend festen Kunststoff hergestellt, beispielsweise einem ABS-Polymeren. Die Verwendung von ausschließlich Kunststoffen im Befestigungsbereich hat sich als ausreichend erwiesen. Um jedoch Herstellungsungenauigkeiten und mögliche spätere Abweichungen, beispielsweise durch Abnutzung, Fließen oder dergleichen, besser ausgleichen zu können, wird in einer Verbesserung vorgeschlagen, im Bereich des Eingriffs der Haken 34 und Nasen 48 elastische Mittel vorzusehen und/oder diesen Bereich durch entsprechende Mittel zu verstärken, beispielsweise durch eingelegte Glasfasern, durch eingelegte Metallarmierungen usw., und/oder die Haken 34 bzw. die Nasen 38 durch einen harten Überzug zu verstärken, beispielsweise mit einer dünnen Metallschicht zu belegen. Eine elastische Ausbildung des Verbindungsbereichs ist dadurch möglich, daß in eine Rille 36 ein elastischer Strang, beispielsweise ein Gummistrang eingelegt wird, daß an dieser Stelle eine gewellte Blattfeder eingefügt wird etc. In einer Alternative können auch an den Spitzen der Haken 34 bzw. der Nasen 48 Noppen vorgesehen sein, die zunächst ein Übermaß haben und in einer Bearbeitungsmaschine soweit abgeschliffen werden, daß ein Normmaß vorliegt. Hierdurch können Herstellungsungenauigkeiten ausgeglichen werden. Schließlich können auch zwischen die sich im gezeigten Ausführungsbeispiel im Montagezustand berührenden freien Kanten 32 zweier Gehäuseschalen 20 elastische Mittel eingelegt werden. Hierzu wird vorgeschlagen, daß beide freien Kanten 32 im Profil gesehen eine Ausnehmung erhalten, in eine Ausnehmung jeder Gehäuseschale 20 wird ein Gummistrang oder dergleichen eingefügt (eingeklebt).

Um den Zusammenbau der beiden Gehäuseschalen 20 eines Gehäuses zu erleichtern, springen an der freien Kante 32 jeweils nur eines Seitenwandteils 24 oder 26 Paßvorsprünge 54 vor, die jeweils andere freie Kante derselben Gehäuseschale 20 hat eine entsprechende Ausnehmung.

Beide Gehäuseschalen 20 eines Gehäuses haben formgleiche Mulden 56 für die Aufnahme eines im wesentlichen U-förmigen, hier nicht dargestellten Bügels, der eine Länge hat, die nur etwas kürzer ist als die Breite des Gerätegehäuses. Für alle Gehäuse werden baugleiche Bügel verwendet. Bei breiteren Gehäuseschalen 20 verbleibt daher im Gegensatz zur Darstellung nach Fig. 1 zwischen der Mulde 56 und dem jeweiligen Seitenwandteil 24, 26 ein breiterer Freiraum. Fig. 1 zeigt die Gehäuseschale geringster Breite. Die Mulde 56 jeder Gehäuseschale 20 befindet sich etwa in der Mitte der Oberwand 22 bzw. Unterwand. Die Mulde 56 bildet im Bereich von von zwei parallel zu den Seitenwandteilen 24, 26 verlaufenden Endbereichen 58 ein Schwenklager für den Bügel aus, hier sind Lagerstifte bzw. Lagerbohrungen vorgesehen, in die ein Bügel eingeklipst werden kann. Die Mulde 56 ist so ausgeführt, daß sie den Bügel in eingeklappter Stellung vollständig aufnimmt, dieser also nicht aus der Ebene der Oberfläche der Oberwand 22 bzw. Unterwand vorsteht. Der Bügel wird in der eingeklappten Position durch elastische Mittel, die einstückige Teile der Gehäuseschale 20 sind, arretiert. Er kann aus dieser Position in mindestens zwei Winkelstellungen, vorzugsweise in drei Winkelstellungen angehoben werden, von denen eine in einem Bereich von 20 bis 70 Grad Schwenkwinkel und weitere im Bereich von ca. 120 ° Schwenkwinkel (jeweils aus der Ruheposition gemessen) liegt und auf jeden Fall eine dieser beiden Positionen, vorzugsweise beide Winkelstellungen eine elastische Arretierung aufweisen. Diese mindestens eine Winkelstellung wird benutzt, um den Traggriff der unteren Gehäuseschale eines Gehäuses als Abstützung für eine Schrägstellung des Gerätegehäuses verwenden zu können. Zusätzlich kann der Bügel in eine Schwenkposition von ca. 90 ° Schwenkwinkel hochgeklappt werden, die nicht notwendigerweise arretierbar sein muß, in dieser Position wird der Bügel (vorzugsweise der oberen Gehäuseschale) als Traggriff benutzt.

Fig. 10 zeigt die frontseitige Ansicht eines Gehäuses, das aus zwei Gehäuseschalen unterschiedlicher Höhe der Seitenwandteile 24, 26 zusammengesetzt ist. Gezeigt ist im wesentlichen der Wulst, andere Einzelheiten der Gehäuseschale 20 sind in der schematischen Darstellung weggelassen. Die Figur soll lediglich verdeutlichen, daß durch Kombination zweier ansonsten vollständig baugleicher, jedoch eine unterschiedliche Höhe der Seitenwandteile aufweisender Gehäuseschalen 20, 21 ein Gehäuse aufgebaut werden kann. Aus der Figur 10 ist unmittelbar abzuleiten, daß durch Ersatz der Gehäuseschale 20 mit den längeren Seitenwandteilen 24, 26 durch eine Gehäuseschale 21 kürzerer Höhe ein flacheres Gehäuse erstellt werden kann und umgekehrt. Dies bedeutet, daß allein mit den zwei unterschiedlichen Gehäuseschalen 20, 21 drei unterschiedliche Gehäuse erstellt werden können.

In den gezeigten Ausführungsbeispielen ist die Höhe der beiden Seitenwandteile 24, 26 jeder Gehäuseschale 20 bzw. 21 jeweils gleich. Grundsätzlich ist dies nicht notwendig, es sind auch Ausführungen möglich, bei denen die Seitenwandteile einer Gehäuseschale 20 unterschiedliche Höhe haben.

Durch geeignete Maßnahmen sind die Gerätegehäuse stapelbar, hierzu sind in den Gehäuseschalen 20, 21 geeignete Ausnehmungen oder Vorsprünge vorgesehen, beispielsweise Ausnehmungen, in die im wesentlichen zylindrische Gummifüße eingesetzt werden können, die von der unteren Gehäuseschale 21 nach unten vorstehen und die in die entsprechenden, leeren Ausnehmungen einer oberen Gehäuseschale 20 eingreifen können. Weiterhin können hinter dem Schieber Justiereinrichtungen, beispielsweise Einstellpotentiometer, Trimmkondensatoren, DIP-Schalter usw. vorgesehen sein, die Bestandteil der im Gerätegehäuse untergebrachten, elektronischen Schaltung sind. Aufgrund der Anordnung in den Seitenwandteilen 24, 26 und verdeckt durch den Riegel 40 können diese Justierteile betätigt werden, ohne das Gerätegehäuse öffnen zu müssen, es genügt ein Zurückziehen oder Abnehmen eines Riegels 40.

## Patentansprüche

1. Gerätegehäuse mit zwei Gehäuseschalen (20), von denen die eine die Oberwand (22) und jeweils ein oberes Seitenwandteil (24, 26) der beiden Seitenwände und die andere die Unterwand und jeweils ein unteres Seitenwandteil der beiden Seitenwände ausbildet, wobei die beiden Gehäuseschalen (20) über an den Seitenwandteilen (24, 26) angeordnete Befestigungsmittel, die eine die Seitenwandteile (24, 26) jeder Seitenwand zusammenziehende Spannkraft ausüben, lösbar miteinander verbindbar sind und im zusammengesetzten Zustand vorn eine rechteckförmige Öffnung für die formschlüssige Aufnahme einer Frontplatte aufweisen, dadurch gekennzeichnet, daß die Befestigungsmittel an der Außenfläche (30) der Seitenwandteile (24, 26) zugängliche, im wesentlichen parallel zur freien Kante (32) des Seitenwandteils (24 bzw. 26) verlaufende und vorzugsweise vorstehende Haken (34) sind, daß die Haken (34) der beiden Seitenwandteile (24 bzw. 26) einer Seitenwand voneinander wegweisen, daß pro Seitenwand ein Riegel (40) vorgesehen ist, der an seiner Innenfläche (46) den Haken (34) angepaßte, aufeinanderzu gerichtete Nasen (48) hat, und daß im zusammengesetzten Zustand die Haken (34) und die Nasen (48) einander wechselseitig hintergreifen.

2. Gerätegehäuse nach Anspruch 1, dadurch gekennzeichnet, daß die Haken (34) und/oder die Nasen (48) als längliche Profile ausgebildet sind.

3. Gerätegehäuse nach Anspruch 1 oder 2, dadurch gekennzeichnet, daß die Haken (34) und/oder die Nasen (48) als Profilteilstücke ausgebildet sind und sich zwischen zwei Profilteilstücken haken- bzw. nasenfreie Unterbrechungsbereiche (44) befinden.

4. Gerätegehäuse nach einem der Ansprüche 1 bis 3, dadurch gekennzeichnet, daß sich die freien Kanten (32) der Seitenwandteile (24, 26) im zusammengesetzten Zustand, gegebenenfalls unter Zwischenlage eines elastischen Mittels, berühren und daß vorzugsweise ein Seitenwandteil (z. B. 24) jeder Gehäuseschale (20) an seiner freien Kante einen Paßvorsprung (54) und das andere Seitenwandteil (z. B. 26) eine diesem Paßvorsprung (54) angepaßte Ausnehmung aufweist.

5. Gerätegehäuse nach einem der Ansprüche 1 bis 4, dadurch gekennzeichnet, daß die Befestigungsmittel jedes Seitenwandteils (24, 26) und die Riegel (40) jeder Seitenwand baugleich ausgeführt sind.

6. Gerätegehäuse nach einem der Ansprüche 1 bis 5, dadurch gekennzeichnet, daß an mindestens einem Seitenwandteil (24) jeder Gehäuseschale (20) und am Riegel (40) Arretierungsmittel für eine lösbare Fixierung der Riegel (40) vorgesehen sind.

7. Gerätegehäuse nach einem der Ansprüche 1 bis 6, dadurch gekennzeichnet, daß die Riegel (40) aus einem flachen, länglichen Riegelstreifen und aus einem quer zu diesem abstehenden, an der Rückwand zur Anlage gelangenden, kurzen Anschlag zusammengesetzt sind.

8. Gerätegehäuse nach einem der Ansprüche 1 bis 7, dadurch gekennzeichnet, daß die Gehäuseschalen (20) im Bereich der Frontplatte einen Wulst (28) aufweisen, dessen Versatz im Bereich der Seitenwände der Breite des Riegels (40) entspricht.

9. Gerätegehäuse nach einem der Ansprüche 1 bis 8, dadurch gekennzeichnet, daß zwischen Riegel (40) und den Haken (34) oder zwischen den freien Kanten (32) der Gehäuseschalen (20) elastische Mittel, insbesondere eine vorzugsweise gewellte Blattfeder, ein Strang aus einem elastischen Material, insbesondere Gummi, angeordnet sind, die die Seitenwandteile (24 oder 26) einer Seitenwand voneinander wegdrücken oder die Nasen (48) des Riegels aufeinanderzu ziehen.

10. Gerätegehäuse nach einem der Ansprüche 1 bis 9, dadurch gekennzeichnet, daß die Gehäuseschale (20) und der Riegel (40) jeweils einstückig aus Kunststoff hergestellt sind und daß vorzugsweise die Haken (34) bzw. Nasen (48) armiert, insbesondere durch Einlegen von Glasfasern oder eines Metallteils armiert oder überdeckt sind, durch einen Überzug aus einem harten Material, insbesondere Metall.

11. Gerätegehäuse nach einem der Ansprüche 1 bis 10, dadurch gekennzeichnet, daß jede Gehäuseschale (20) im Bereich ihrer Oberwand (22) bzw. Unterwand eine formgleiche Mulde (56) aufweist.

12. Gerätegehäuse nach Anspruch 11, dadurch gekennzeichnet, daß in die Mulde beider Gehäuseschalen (20) eines Gehäuses jeweils ein U-förmiger, tragegriffähnlicher Bügel eingeklippt ist, der um eine quer zur Ebene der Seitenwand verlaufende Schwenkachse schwenkbar gelagert ist und in drei Winkelpositionen einstellbar ist, von denen zumindest eine durch elastische Rastmittel gehalten ist, wobei der Bügel in einer ersten Stellung unbenutzt und vollständig versenkt in der Mulde angeordnet ist, in einer zweiten Stellung der Bügel eine Schrägstellung des Gehäuses auf einer Unterlage ermöglicht und teilweise aus der Ebene der Oberwand (22) bzw. Unterwand vorsteht und in einer dritten Stellung der Bügel ca. 90° geschwenkt für die Benutzung als Tragegriff vorsteht.

## Claims

1. Housing for appliances with two shells (20), one of which forms the upper wall (22) and the two upper sections (24, 26) of the two side walls while the other forms the lower wall and the two lower sections of the two side walls. The two shells (20) of the housing are provided with releasable fastening means which are located on the side wall components (24, 26) of each side wall and which exert a clamping force between the upper and lower side wall components (24, 26), thus clamping them together. When assembled, the two shells of the housing have a rectangular front opening to allow the form-fitting reception of a front panel. The housing for appliances is characterised by the fact that the fastening means comprise hooks (34) arranged accessibly on the outer surface (30) of the side wall sections (24, 26), preferably projecting and running essentially parallel to the free edge (32) of the side wall sections (24, 26); and that the hooks (34) on the two sections of each side wall (24, 26) point away from one another; and that each side wall is provided with a sliding fastener (40), the inner surface (46) of which is provided with noses (48) facing towards one another and fitting the hooks (34); and that when the housing is assembled, the hooks (34) and the noses (48) engage in one another.

2. Housing for appliances as claimed in Claim 1, characterised by the fact that the hooks (34) and/or noses (48) have the form of longitudinal sections running along the side walls.

3. Housing for appliances as claimed in Claims 1 or 2, characterised by the fact that the hooks (34) and/or noses (48) have the form of partial sections and that hook-free and nose-free spaces (44) are located between these partial sections.

4. Housing for appliances as claimed in any of Claims 1 to 3, characterised by the fact that when assembled the free edges (32) of the side wall sections (24, 26) touch one another, optionally with an elastic means placed between them, and that preferably one side wall section (e.g. 24) of each housing shell (20) is provided with a locating protuberance (54) on its free edge (32) while the other side wall section (e.g. 26) is provided with a recess corresponding to this locating protuberance (54).

5. Housing for appliances as claimed in any of Claims 1 to 4, characterised by the fact that the fastening means of each side wall section (24, 26) and the sliding fasteners (40) of each side wall are identical.

6. Housing for appliances as claimed in any of Claims 1 to 5, characterised by the fact that at least one side wall section (24) of each housing shell (20) and the sliding fastener (40) are provided with locking means (spring tongue (52) and recess) for releasably locking the sliding fastener (40) into position.

7. Housing for appliances as claimed in any of Claims 1 to 6, characterised by the fact that the sliding fasteners (40) comprise a flat, oblong fastener strip and a short stop (50) which projects at right angles to this strip and which stops the fastener against the rear panel.

8. Housing for appliances as claimed in any of Claims 1 to 7, characterised by the fact that the housing shells (20) are provided in the area of the front panel with a rim (28) whose offset from the plane of the side walls corresponds to the thickness of the sliding fastener (40).

9. Housing for appliances as claimed in any of Claims 1 to 8, characterised by the fact that elastic means, in particular a preferably corrugated leaf spring or a strand of elastic material, in particular rubber, is provided between the sliding fastener (40) and the hooks (34) or between the free edges (32) of the housing shells (20), and that said elastic means either push the side wall sections (24 or 26) of a side wall away from one another or pull the noses (48) of the sliding fastener (40) towards one another.

10. Housing for appliances as claimed in any of Claims 1 to 9, characterised by the fact that the housing shell (20) and the sliding fastener (40) are both made of single pieces of plastic and that the hooks (34) and noses (48) are preferably reinforced, in particular that they are reinforced by the insertion of glass fibres or a metal component, or that they are covered with a coating of a hard material, in particular metal.

11. Housing for appliances as claimed in any of Claims 1 to 10, characterised by the fact that each housing shell (20) is provided in its upper/lower wall (22) with an identically-shaped cavity (56).

12. Housing for appliances as claimed in Claim 11, characterised by the fact that a U-shaped bracket with form similar to that of a carrying handle is clipped into the cavity (56) of each of the housing shells (20) of the housing and that said bracket is mounted so as to be swivellable along an axis running perpendicular to the plane of the side wall and can be adjusted to three angled positions, and that elastic means are provided for securing the bracket in at least one of these positions; in the first position (0°), the bracket is unused and is lowered completely into the cavity (56); placing the bracket in the second position (between 30° and 120°) allows the housing to be placed in a tilted position on a supporting surface, with the bracket projecting partially above the plane of the surface of the upper or lower wall (22); in the third position the bracket is swivelled to an angle of approx. 90° to project from the casing for use as a carrying handle.

## Revendications

1. Boîtier bicoque (20) pour appareils, une coque forme la paroi supérieure (22) et respectivement une partie de paroi latérale supérieure (24, 26) des deux parois latérales et l'autre la paroi inférieure et respectivement une partie de paroi latérale inférieure des deux parois latérales, les deux coques (20) amovibles reliables entre elles par l'intermédiaire de moyens de fixation qui exercent un effort de tension serrant les parties de paroi latérale (24, 26) de chaque paroi latérale, placés aux deux parois latérales, présentant à l'avant, à l'état assemblé, une ouverture carrée pour le logement positif d'une plaque frontale, caractérisé en ce que les moyens de fixation sont des crochets (34) de préférence saillants, en grande partie allant parallèlement au bord libre (32) de la partie de paroi latérale (24 voire 26), accessibles à la surface extérieure (30) des parties de paroi latérale (24, 26), que les crochets (34) des deux parties de paroi latérale (24 voire 26) d'une paroi latérale s'opposent, qu'est prévu à chaque paroi latérale un verrouillage (40) ayant à sa surface des nez (48) dirigés les uns vers les autres et adaptés intérieure (46) aux crochets (34) et qu'en état assemblé, les crochets (34) et les nez (48) s'accrochent réciproquement les uns dans les autres.

2. Boîtier pour appareils selon la revendication 1, caractérisé en ce que que les crochets (34) et/ou les nez (48) ont des formes profilées oblongues.

3. Boîtier pour appareils selon la revendication 1 ou 2, caractérisé en ce que les crochets (34) et/ou les nez (48) sont des pièces profilées et qu'entre deux pièces profilées il y a des zones d'interruption (44) sans crochet voire sans nez.

4. Boîtier pour appareils selon l'une des revendications 1 à 3, caractérisé en ce que les bords libres (32) des parties de paroi latérales (24, 26) à l'état assemblé, se touchent, le cas échéant en intercalant un élément élastique et que de préférence une partie de paroi latérale (p. ex. 24) de chaque coque du boîtier (20) possède à son bord libre une partie saillante d'ajustage (54) et que l'autre partie de paroi latérale (p. ex. 26) un creux adapté à cette partie saillante d'ajustage (54).

5. Boîtier pour appareils selon l'une des revendications 1 à 4, caractérisé en ce que les moyens de fixation de chaque partie de paroi latérale (24, 26) et le verrouillage (40) de chaque paroi latérale sont de même construction.

6. Boîtier pour appareils selon l'une des revendications 1 à 5, caractérisé en ce qu'à au moins une partie de paroi latérale (24) de chaque coque de boîtier (20) et au verrouillage (40), des moyens d'arrêt sont prévus en vue d'une fixation amovible des verrouillages (40).

7. Boîtier pour appareils selon l'une des revendications 1 à 6, caractérisé en ce que les verrouillages (40) sont composés d'une bande de verrouillage plate et oblongue et d'une butée courte espaçant perpendiculairement celle-ci, arrivant à l'installation à la paroi arrière.

8. Boîtier pour appareils selon l'une des revendications 1 à 7, caractérisé en ce que les coques de boîtier (20) présentent dans la zone de la plaque frontale un renflement (28) dont le déport dans la zone des parois latérales correspond à la largeur du verrouillage (40).

9. Boîtier pour appareils selon l'une des revendications 1 à 8, caractérisé en ce qu'entre le verrouillage (40) et les crochets (34) ou entre les bords libres (32) des coques de boîtier (20) sont placés un élément élastique et en particulier un ressort à lame de préférence ondulé, un cordon d'un matériau élastique et en particulier du caoutchouc qui repoussent l'une de l'autre les parties de paroi latérale (24 ou 26) d'une paroi latérale ou qui tirent l'un vers l'autre les nez (48) du verrouillage.

10. Boîtier pour appareils selon l'une des revendications 1 à 9, caractérisé en ce que la coque de boîtier (20) et le verrouillage (40) sont fabriqués chacun en une seule pièce en matière synthétique et que de préférence les crochets (34) voire les nez (48) sont armés, en particulier armés en y intégrant des fibres de verre ou une partie de métallique ou couverts d'une couche de matériau dur, en particulier du métal.

11. Boîtier pour appareils selon l'une des revendications 1 à 10, caractérisé en ce que chaque coque de boîtier (20) présente une cavité (56) ayant la même forme dans la zone de la paroi supérieure (22) et dans celle de la paroi inférieure.

12. Boîtier pour appareils selon la revendication 11, caractérisé en ce que dans la cavité des deux coques (20) d'un boîtier est attaché respectivement un étrier en forme de U, semblable à une poignée de manutention, logé de façon orientable autour d'un pivot allant diagonalement par rapport à la surface de la paroi latérale, réglable en trois positions d'angles dont au moins une est tenue par un élément d'enclenchement élastique, l'étrier étant placé dans une première position de non utilisation et entièrement plongé dans la cavité, dans une deuxième position l'étrier permettant une position oblique du boîtier sur un support et dépassant partiellement du niveau de la paroi supérieure (22) voire de la paroi inférieure et dans une troisième position, orienté à 90°, l'étrier dépassant et servant à l'utilisation en tant que poignée.
